## Europäisches Patentamt

## European Patent Office

## Office européen des brevets

(19)

(11) Veröffentlichungsnummer: **0 012 796**
B1

(12)

# EUROPÄISCHE PATENTSCHRIFT

(45) Veröffentlichungstag der Patentschrift:
13.04.83

(51) Int. Cl.³: **G 11 C 8/00**, G 11 C 11/40,
H 03 K 3/286

(21) Anmeldenummer: 79103606.4

(22) Anmeldetag: 24.09.79

(54) Speicheranordnung mit Speicherzellen zum gleichzeitigen Einlesen und Auslesen von Information.

(30) Priorität: 02.01.79 US 58

(43) Veröffentlichungstag der Anmeldung:
09.07.80 Patentblatt 80/14

(45) Bekanntmachung des Hinweises auf die Patenterteilung:
13.04.83 Patentblatt 83/15

(84) Benannte Vertragsstaaten:
DE FR GB NL SE

(56) Entgegenhaltungen:
US-A-3 471 838
US-A-3 643 236
US-A-3 675 218
US-A-3 761 898
US-A-3 781 828
US-A-3 968 480
US-A-4 070 657
US-A-4 125 877
US-A-4 127 899
IBM TECHNICAL DISCLOSURE BULLETIN,
Band 13, Nr. 3, August 1970, Armonk, US, BER-
DING: »Simultaneous read-write monolithic storage cell«, Seite 620

(73) Patentinhaber: International Business Machines
Corporation, Armonk, N.Y. 10504 (US).

(72) Erfinder: Gersbach, John Edwin, 500 South Willard St.,
Burlington, VT 05401 (US)

(74) Vertreter: Böhmer, Hans Erich, Dipl.-Ing., Schönaicher
Strasse 220, D-7030 Böblingen (DE)

**PROCEEDINGS OF THE FALL JOINT COMPUTER
CONFERENCE, Afips, Band 29, 1966, Washington,
US, CATT et al.: »A high-speed I.C. scratchpad
memory«, Seiten 315—331
IBM TECHNICAL DISCLOSURE BULLETIN,
Band 21, Nr. 7, Dezember 1978, Armonk, US, TING
et al.: »Memory with double word readout«,
Seiten 2831—2832
IEEE PROCEEDINGS OF THE TEXAS CONFE-
RENCE ON COMPUTING SYSTEMS, November
1975, Long Beach, US, CHU et al.: »Multi-access
memory: an overview«, Seiten 2B-1.1 bis 28-1.8**

Anmerkung: Innerhalb von neun Monaten nach der Bekanntmachung des Hinweises auf die Erteilung des europäischen
Patents im Europäischen Patentblatt kann jedermann beim Europäischen Patentamt gegen das erteilte europäische Patent
Einspruch einlegen. Der Einspruch ist schriftlich einzureichen und zu begründen. Er gilt erst als eingelegt, wenn die
Einspruchsgebühr entrichtet worden ist (Art. 99(1) Europäisches Patentübereinkommen).

**Speicheranordnung mit Speicherzellen zum gleichzeitigen Einlesen und Auslesen von Information**

Die Erfindung betrifft eine Speicheranordnung zum gleichzeitigen Lesen und Schreiben mit zeilen- und spaltenweise angeordneten, aus einem Paar kreuzgekoppelten Transistoren bestehenden Speicherzellen und einem Paar Schreibtransistoren, mit einem Lesedecodierer und einem Schreibdecodierer, die voneinander unabhängig mit den Speicherzellen verbunden sind, wobei die Speicherzellen jeder Zeile an einer der Wortschreibleitungen des Schreibdecodierers und an einer der Wortleseleitungen des Lesedecodierers angekoppelt sind und die Speicherzellen jeder Spalte zwischen einem Paar von Bit-Leseleitungen und einem Paar von Bit-Schreibleitungen eingeschaltet sind, wobei zwei Bezugsknotenpunkte einer jeden Speicherzelle an die beiden dazugehörigen Bitleseleitungen ankoppelbar sind und die beiden Schreibtransistoren jeder Speicherzelle von dem zugeordneten Paar von Bitschreibleitungen und den zugeordneten Wortschreibleitungen angesteuert werden und ausgangsseitig auf die Bezugsknotenpunkte wirken und wobei ferner simultan in Speicherzellen derselben Spalte ausgelesen und eingeschrieben werden kann.

Zum Stand der Technik offenbart die US-A-3 177 374 eine binäre Datenübertragungsschaltung, die eine übliche bistabile Schaltung als Speicherzelle benutzt. An jede Zelle ist eine Übertragungsschaltung für die Übertragung der in dieser Zelle eingespeicherten Daten nach einer zweiten kreuzgekoppelten Zelle angekoppelt.

Die US-A-3 675 218 offenbart eine Speicheranordnung, bei der Information in jedem beliebigen Teil der Anordnung eingeschrieben werden kann, während gleichzeitig Information aus einem anderen, davon verschiedenen Teil der Anordnung ausgelesen wird.

Die US-A-3 504 351 offenbart eine Matrix aus bistabilen Datenzellen, bei welchen die Information zwischen den an die gleiche Abfühlleitung angekoppelten Zellen übertragen werden kann, wobei jede Zeile, die in einen Betriebszustand zur Aufnahme von Information versetzt ist, sich außerdem in einem Betriebszustand befindet, in dem die Weiterübertragung des Signals nach anderen Zellen längs der Abfühlleitung verhindert wird.

Zum Stand der Technik zeigt die US-A-4 127 899 der Anmelderin eine aus Transistorspeicherzellen aufgebaute Speichermatrix, bei der jede Speicherzelle getrennte Wortleitungen für Schreiben und Lesen und außerdem getrennte Bitleitungen für Schreiben und Lesen aufweist, so daß jede Zelle gleichzeitig geschrieben und gelesen werden kann. Mit dieser bekannten Schaltung ist es jedoch nicht möglich, ohne Umwege die soeben gelesene Information in einer anderen Zeile der gleichen Spalte des Speichers wieder einzuspeichern.

Ferner ist aus US-A-3 761 898 ein Speicher mit wahlfreiem Zugriff bekannt, bei dem gleichzeitig binäre Daten eingespeichert und zuvor eingespeicherte Daten ausgelesen werden können. Dazu sind jeweils gesonderte Wortleitungen für Lesen und Schreiben sowie gesonderte Bitleitungen für Lesen und Schreiben vorgesehen. Damit ist jedoch ein gleichzeitiges Wiedereinspeichern der soeben ausgelesenen Speicherzelle in einer anderen Speicherzelle der gleichen Spalte einer Speichermatrix nicht möglich.

Der Erfindung liegt die Aufgabe zugrunde, bei Speicheranordnungen der eingangs genannten Art zu ermöglichen, eine soeben ausgespeicherte Information ohne Umwege unmittelbar wieder in einer anderen Speicherzelle der gleichen Spalte wieder einzuspeichern.

Die obengenannte, der Erfindung zugrunde liegende Aufgabe wird nunmehr dadurch gelöst, daß eine Rückkopplungsschaltung für jede Spalte vorgesehen ist, die jeweils mit dem Paar von Bit-Leitungen dieser Spalte über ein Paar von Rückkopplungsleitungen verbunden ist und zwei Umschalter aufweist, die wahlweise ein Paar von Datenbiteingangsleitungen oder das Paar von Rückkopplungsleitungen an das Paar von Bitschreibleitungen anschalten.

Die vorliegende Erfindung eignet sich insbesondere als Arbeitsspeicher in Hochleistungs-Mikroprozessoren.

Die Erfindung wird nunmehr anhand eines Ausführungsbeispiels in Verbindung mit den Zeichnungen im einzelnen näher erläutert.

In den Zeichnungen zeigt

Fig. 1 ein Blockschaltbild einer Anordnung von Speicherzellen mit den erforderlichen peripheren Schaltungen,

Fig. 2 ein Blockschaltbild einer Ausführungsform einer der Spalten der Speicherzellen in Fig. 1.

Beschreibung
der bevorzugten Ausführungsform

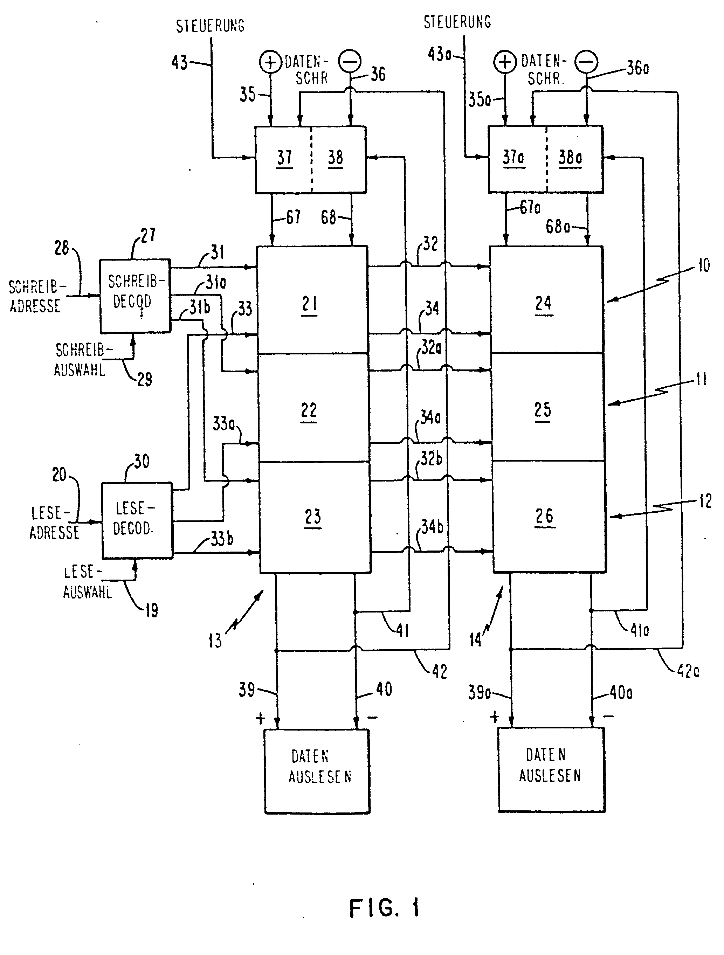

Fig. 1 zeigt eine erfindungsgemäß aufgebaute Speicheranordnung mit einer Anzahl Speicherzellen, die als eine aus sechs Speicherzellen bestehende Matrix angeordnet ist. Selbstverständlich kann die Matrix in jeder Richtung ausgedehnt werden, ohne daß dies die Erfindung beeinflußt. Die in Fig. 1 gezeigte Anordnung hat drei Zeilen 10, 11 und 12 und zwei Spalten 13 und 14. Die sechs Speicherzellen 21, 22, 23, 24, 25, 26 sind so angeordnet, daß die Speicherzellen 21 und 24 die erste Zeile 10, die Speicherzellen 22 und 25 die zweite Zeile 11, und die Speicherzellen 23 und 26 die dritte Zeile 12 bilden. Die Speicherzellen 21, 22 und 23 bilden dabei die erste Spalte 13 und die Speicherzellen 24, 25 und 26 bilden die zweite Spalte 14. Die Spalten der Speicherzellen bilden die Bit-Dimension und die Zeilen 10, 11 und 12 die Wort-Dimension der Speicheranordnung. Jede Zeile von Speicherzellen wird durch zwei Decodierer 27 und 30 angesteuert. Der Decodierer 27 ist ein Schreibdecodierer und bestimmt das einzuschreibende Wort und der Decodierer 30 ist ein Lesedecodierer und bestimmt das auszulesende Wort. Jede der Speicherzellen 21, 22, 23, 24, 25 und 26 ist an dem Schreibdecodierer 27 angeschlossen, der das Einschreiben von Information zur Speicherung in die Speicherzellen steuert. Ferner ist jede dieser Speicherzellen am Lesedecodierer 30 angeschlossen, der das Auslesen von Information aus diesen Zellen steuert. Die Speicherzellen 21 und 24 der ersten Zeile 10 der Speicherzellen sind über Wort-Schreibleitungen 31 und 32 am Schreibdecodierer 27 und über Wort-Leseleitungen 33 und 34 am Lesedecodierer 30 angeschlossen. Die anderen Zeilen der Speicherzellen sind in gleicher Weise an diesen Decodierern angeschlossen. Das heißt, daß die zweite Zeile 11 der Speicherzellen 22 und 25 über die Wort-Schreibleitungen 31a und 32a mit dem Schreibdecodierer 27 und über die Wort-Leseleitungen 33a und 34a mit dem Lesedecodierer 30 verbunden ist, während die dritte Reihe 12 der Speicherzellen, d. h. die Speicherzellen 23 und 26 über Wort-Schreibleitungen 31b und 32b mit dem Schreibdecodierer 27 und über Wort-Leseleitungen 33b und 34b mit dem Lesedecodierer 30 verbunden sind.

Jede Spalte von Speicherzellen ist mit einem Paar von Schreib-Eingangsleitungen, einem Schalter und einem Paar Bit-Leseleitungen versehen. Somit weist die aus den Speicherzellen 21, 22 und 23 bestehende Spalte 13 ein Paar Datenbit-Eingangsleitungen 35, 36 auf, die über ein Paar Schalter 37, 38 und ein Paar allen Speicherzellen dieser Spalte gemeinsame Schreibleitungen 67 und 68 mit den Speicherzellen 21, 22 und 23 gekoppelt sind. Diese Speicherzellen sind außerdem an den gemeinsamen Bit-Leseleitungen 39 und 40 angeschlossen. Diese Bit-Leseleitungen 39 und 40 sind über Rückkopplungsleitungen 41 und 42 nach den Schaltern 37 bzw. 38 rückgekoppelt.

Die Spalte 14 ist in gleicher Weise über Schreibeingangsleitungen 35a und 36a und Schalter 37a und 38a sowie Bit-Schreibleitungen 67a und 68a angeschlossen und über Bit-Leseleitungen 39a und 40a über Rückkopplungsleitungen 41a und 42a an den Schaltern 37a bzw. 38a angeschlossen.

Die Schalter 37 und 38 könnten aus einem Paar in ODER-Verknüpfung zusammengeschalteten UND-Gliedern bestehen und weisen eine gemeinsame Steuerleitung 43 auf, während die Schalter 37a und 38a eine gemeinsame Steuerleitung 43a aufweisen. Der Schreibdecodierer 27 ist mit einer Schreibadreßleitung 28 und einer Schreibauswahlleitung 29 versehen, während der Lesedecodierer 30 mit einer Leseadreßleitung 20 und einer Leseauswahlleitung 19 versehen ist. Die Schalter 37 und 38 sind dabei so aufgebaut, daß sie entweder ein von den Datenbit-Eingangsleitungen 35 und 36 oder ein von den Rückkopplungsleitungen 41 und 42 kommendes Schreibsignal durchlassen. Der Schreibdecodierer 27 in Verbindung mit einem auf Adreß-Schreibleitung 28 liegenden Adreß-Schreibsignal und einem auf Schreib-Auswahlleitung 29 liegenden Wort-Auswahlsignal wählt damit eine gegebene Zeile von Speicherzellen aus, so daß Information eingeschrieben werden kann. Der Lesedecodierer 30 ist für das Auslesen von Information längs einer Reihe von Speicherzellen erforderlich. Das Auslesen einer ausgewählten Zeile findet dann statt, wenn auf der Adreß-Leseleitung 20 und der Lese-Auswahlleitung 19 ein entsprechendes Signal liegt.

Das Auslesen einer Reihe von Speicherzellen kann durchgeführt werden, während gleichzeitig die ausgelesene Information in eine andere Reihe von Speicherzellen eingeschrieben wird. Das Auslesen und Einschreiben kann in verschiedenen Reihen von Speicherzellen gleichzeitig durchgeführt werden, d. h. wenn beispielsweise der Lesedecodierer 30 zur Auswahl der Zeile 10, d. h. der Speicherzellen 21 und 24 zum Auslesen der darin enthaltenen Information angesteuert wird, dann wird diese Information über die Bit-Leseleitungen 39 und 40 sowie 39a und 40a ausgelesen und kann gleichzeitig in eine der anderen Zeilen 11 oder 12 dadurch eingelesen werden, daß der Schreibdecodierer 27 eine der anderen Zeilen von Speicherzellen auswählt und die Rückkopplungsleitungen über die Schalter an die Bit-Schreibleitungen 67, 68, 67a und 68a für die Speicherzellen ankoppelt. Die aus einer bestimmten Zeile von Speicherzellen ausgelesene Information kann somit sofort und unmittelbar ohne Verzögerung nach einer anderen Zeile von Speicherzellen übertragen werden, ohne daß dadurch das Auslesen der Information aus den ausgewählten Speicherzellen in irgendeiner Weise beeinflußt wird. Die erfindungsgemäß aufgebaute Schaltung gestattet somit das gleichzeitige Einschreiben von Information, die aus einer Zeile von Speicherzellen ausgelesen wird, in eine andere Zeile von Speicherzellen unter Beibehaltung der Spalten.

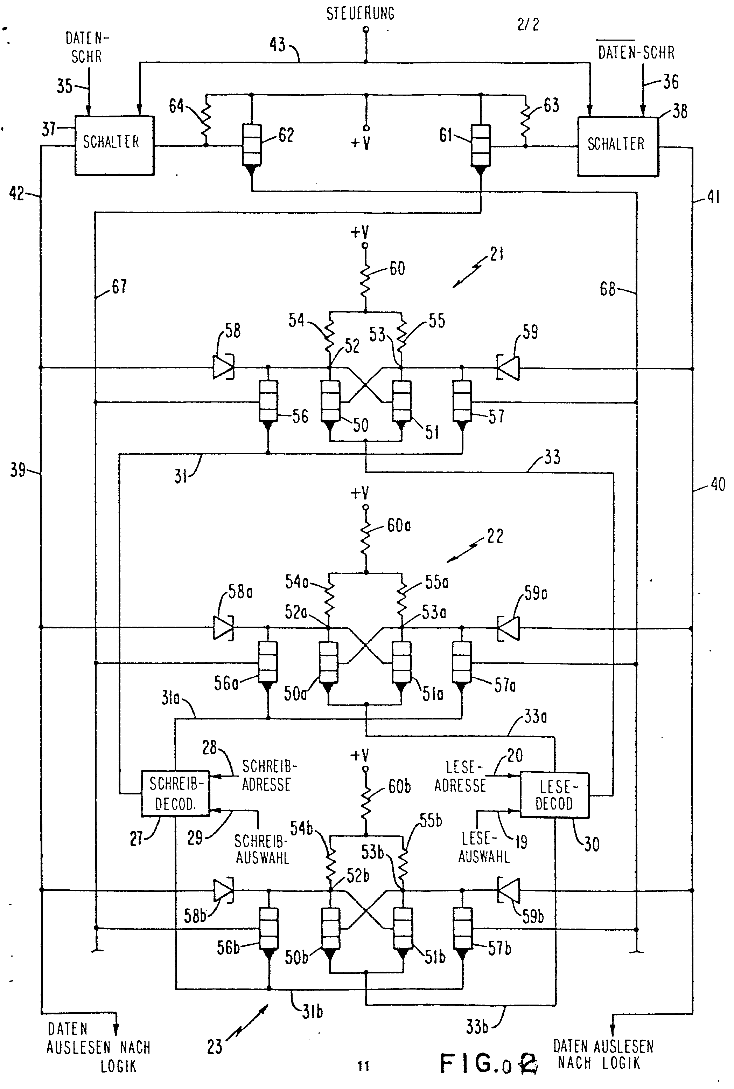

Fig. 2 zeigt im einzelnen die Spalte 13 und jede der darin enthaltenen Speicherzellen 21, 22 und 23 mit ihren zugeordneten Schaltern, Decodierern und Übertragungsschaltungen. Wie aus der Fig. 2 zu ersehen, sind die einzelnen Speicherzellen miteinander identisch aufgebaut, so daß nur eine Speicherzelle hier beschrieben werden soll. Die Speicherzelle 21 besteht beispielsweise aus einem Paar kreuzgekoppelter Transistoren 50 und 51, die als bistabile Kippschaltung geschaltet sind, wobei die Basiselektrode jedes Transistors mit der Kollektorelektrode des jeweils anderen Transistors verbunden ist. Die Emitterelektroden sind miteinander verbunden und an den Lesedecodierer 30 über die Wort-Leseleitung 33 angeschlossen.

Die Kollektorelektrode jedes der kreuzgekoppelten Transistoren 50 und 51 ist zusätzlich zu ihrer Verbindung mit der Basis des jeweils anderen Transistors außerdem über einen entsprechenden Knotenpunkt 52, 53 über einen Lastwiderstand 54 bzw. 55 und gemeinsam über einen dritten Widerstand 60 an einer Spannungsquelle +V angeschlossen. Der Widerstand 60 könnte für alle Speicherzellen einer Zeile gemeinsam vorgesehen sein.

Parallel zu den kreuzgekoppelten Transistoren 50 und 51 sind ein Paar Schreibtransistoren 56 und 57 vorgesehen. Die Emitterelektroden der Schreibtransistoren 56 und 57 sind zusammengeschlossen und über die Schreibwortleitung 31 am Schreibdecodierer 27 angeschlossen. Die Kollektorelektrode jedes der Schreibtransistoren 56 bzw. 57 ist an den zugehörigen Knotenpunkt 52 bzw. 53 angeschlossen. Die Basiselektrode der Schreibtransistoren 56 bzw. 57 ist über einen als Emitterfolger geschalteten Transistor 61 bzw. 62 an einem der Schalter 37 bzw. 38 angeschlossen. Somit ist also die Basis des Schreibtransistors 56 über Bit-Schreibleitung 67 an der Emitterelektrode des als Emitterfolger geschalteten Transistors 61 angeschlossen, während die Basiselektrode des Schreibtransistors 57 über Bit-Schreibleitung 68 am Emitter des als Emitterfolger geschalteten Transistors 62 angeschlossen ist.

An den Knotenpunkten 52 und 53 sind außerdem noch Schottky-Sperrschichtdioden 58 bzw. 59 angekoppelt. Diese Dioden sind dabei so gepolt, daß jeweils die Kathode an dem zugehörigen Knotenpunkt liegt und daß die Anoden demgemäß mit der entsprechenden Bit-Leseleitung 39 bzw. 40 verbunden sind.

Die als Emitterfolger geschalteten Transistoren 61 und 62 sind mit ihren Kollektorelektroden an einer gemeinsamen Spannungsquelle +V und über einen Widerstand 63 bzw. 64 an ihrer eigenen Basiselektrode angeschlossen. Die Basiselektroden dieser Transistoren 61 und 62 sind außerdem am Schalter 37 bzw. 38 angeschlossen. Am Schalter 37 ist die Datenbit-Eingangsleitung 35 und die Steuerleitung 43 angeschlossen, während am Schalter 38 die Datenbit-Eingangsleitung 36 und ebenfalls die Steuerleitung 43 angeschlossen ist. Die Rückkopplungsleitung 41 ist dabei mit einem Eingang des Schalters 38 und die Rückkopplungsleitung 42 mit einem Eingang des Schalters 37 verbunden. Somit ist also die Rückkopplungsleitung 41 zwischen dem Schalter 38 und der Bit-Leseleitung 40 eingeschaltet, und die Rückkopplungsleitung 42 ist zwischen dem Schalter 37 und der Bit-Leseleitung 39 eingeschaltet.

Wie bereits erläutert, sind die anderen Speicherzellen der Speicheranordnung genau so aufgebaut, wie die soeben beschriebene Speicherzelle. Daher sind gleiche Bauelemente der Speicherzelle 22 mit den gleichen Bezugszeichen versehen, jedoch mit dem Index a, während in der Speicherzelle 23 bei den gleichen Bezugszeichen der Index b verwendet ist.

Die soeben beschriebene Schaltung arbeitet dabei wie folgt: Es sei zunächst angenommen, daß die Speicherzelle 21 bereits eingeschrieben ist und Information aus der Speicherzelle 21 nach der Speicherzelle 22 übertragen werden soll. Die Speicherzelle 23 soll dabei im Bereit-Zustand sein. Es sei ferner angenommen, daß in der Speicherzelle 21 der Transistor 50 leitet und der Transistor 51 gesperrt ist, und daß das Leiten des Transistors 50 und das Nichtleiten des Transistors 51 eine in der Speicherzelle 21 eingespeicherte 1 anzeigt. Zur Auswahl eines bestimmten Wortes oder einer Zeile zum Auslesen wird ein Lese-Adreß-Impuls über Leitung 20 zusammen mit einem über Leitung 19 zugeführten negativ gerichteten Lese-Auswahl-Impuls zugeführt. Diese beiden Impulse gelangen an den Lesedecodierer 30, was zur Folge hat, daß das Potential auf der Wort-Leseleitung 33 abgesenkt wird, so daß auch die Emitterelektroden der beiden kreuzgekoppelten Transistoren 50 und 51 aus ihrem Ruhezustand auf niedriges Potential abgesenkt werden. Wenn das Potential an den Emitterelektroden der Transistoren 50 und 51 niedrig wird, dann nimmt der durch den Transistor 50 fließende Strom wesentlich über den im Ruhezustand fließenden Strom zu, der dann fließt, wenn die Wort-Leseleitung 33 auf ihrer normalen Ruhespannung liegt. Die Zunahme des durch den Transistor 50 fließenden Stroms hat zur Folge, daß das Potential am Knotenpunkt 52 ebenfalls unter das Ruhepotential abfällt, so daß die Schottky-Sperrschichtdiode 58 leitend wird, womit die Bit-Leseleitung 39 etwa angenähert das Potential des Knotenpunktes 52 annimmt.

Da der Transistor 51 gesperrt war, bleibt der Knotenpunkt 53 im wesentlichen auf seinem Ruhepotential, und die Schottky-Sperrschichtdiode 59 bleibt gesperrt. Die Bit-Leseleitung 40 bleibt ebenfalls auf ihrem Ruhepotential. Dies hat zur Folge, daß die in der Speicherzelle eingespeicherte Information über den beiden Bit-Leseleitungen 39 und 40 als eine Spannungsdifferenz auftritt, die durch geeignete Leseschaltungen gelesen werden kann.

Falls es erwünscht ist, dabei gleichzeitig die aus der Speicherzelle 21 ausgelesene Information in eine der benachbarten Speicherzellen, wie z. B. die Speicherzelle 22, einzuschreiben, dann ist es erforderlich, daß gleichzeitig mit dem Auslesen der Speicherzelle 21 die Speicherzelle 22 in ihren Einschreib-Betriebszustand gebracht wird. Dies wird dadurch erreicht, daß an die Schreib-Auswahlleitung 29 ein negativer Schreib-Auswahl-Impuls gleichzeitig mit einem über Adreß-Schreibleitung 28 zugeführten Adreß-Schreib-Impuls zugeführt wird, so daß die Wort-Schreibleitung 31a der Speicherzelle 22 unter ihr Ruhepotential abgesenkt wird. Damit werden aber die Emitterelektroden der Schreibtransistoren 56a und 56b auf ein niedrigeres Potential gebracht, so daß diese leitend werden, wodurch die Information über die Bit-Schreibleitungen 67 und 68 in die Speicherzelle 22 eingeschrieben werden kann.

Die durch das Auslesen der Speicherzelle 21 auf den Bit-Leseleitungen 39 und 40 auftretende Information kann auch dadurch an die Bit- Schreibleitungen 67 und 68 abgegeben werden, daß die Steuerleitung 43 so eingestellt wird, daß die Schalter 37 und 38 die von den Bit-Leseleitungen 39 und 40 über Rückkopplungsleitungen 41 und 42 ankommende Information nach den Bit-Schreibleitungen 67 und 68 weitergeleitet wird. Wenn ein Steuersignal den Schaltern 37 und 38 in der Weise zugeleitet wird, daß die Rückkopplungsleitungen 41 und 42 nunmehr an den Basiselektroden der als Emitterfolger geschalteten Transistoren 62 und 61 angekoppelt sind, dann wird in dem angegebenen Augenblick, wenn die Speicherzelle 21 ausgelesen wird, die an der Bit-Leseleitung 39 angekoppelte Rückkopplungsleitung 42 ebenfalls etwa auf das Potential des Knotenpunkts 52 gebracht. Wird dieses Signal über Schalter 37 der Basiselektrode des Transistors 62 zugeleitet, dann wird dieser gesperrt gehalten. Außerdem ist die Ruhespannung auf der Bit-Leseleitung 40 über die Rückkopplungsschleife 41 und Schalter 38 an die Basis des Transistors 61 angekoppelt, wodurch dieser eingeschaltet wird. Wenn der Transistor 61 eingeschaltet wird, dann geht die Basisspannung aller Schreibtransistoren 56, 56a und 56b nach +V. Da jedoch nur beim Transistor 56a die Spannung an der Emitterelektrode unter ihre Ruhespannung abgesenkt ist, schaltet nur der Schreibtransistor 56a ein, während die Schreibtransistoren 56 und 56b gesperrt bleiben. Dies hat zur Folge, daß das Potential am Knotenpunkt 52a und die Basiselektrode des Transistors 51a auf diejenige Spannung abgesenkt wird, die durch den Schreibdecodierer 27 an die Leitung 31a angelegt ist, wodurch der Transistor 51a gesperrt wird, wenn er eingeschaltet ist. Wegen der Kreuzkopplung der Transistoren 50a und 51a schaltet Transistor 50a ein. Somit werden die Transistoren 50a und 51a in den gleichen Betriebszustand eingestellt, in dem sich die Transistoren 50 und 51 der Speicherzelle 21 befanden, als sie ausgelesen wurde. Wegen dieser Schreibdecodierung bleiben die Wort-Schreibleitungen 31 und 31b der Speicherzellen 21 und 23 auf ihrer normalen Ruhespannung, und die an der Bit-Schreibleitung 67 liegende Spannung reicht nicht aus, Information in die Speicherzelle 21 oder 23 einzuschreiben. Da der als Emitterfolger geschaltete Transistor 62 durch die auf der Bit-Leseleitung 39 liegende Spannung gesperrt gehalten wird, bleiben die Schreibtransistoren 57, 57a und 57b alle gesperrt, und an den Knotenpunkten 53, 53a und 53b erfolgt im wesentlichen keine Potentialänderung. Obgleich die Information nunmehr aus der Speicherzelle 21 ausgelesen und nach der Speicherzelle 22 übertragen wurde, so war dies doch ein zerstörungsfreies Auslesen, d. h., die Information liegt nach wie vor in der Speicherzelle 21.

Nach Auslesen der Speicherzelle 21 und Übertragung der darin enthaltenen Information nach der Speicherzelle 22 kann neue Information in die Speicherzelle 21 eingegeben werden. Dies wird wie folgt durchgeführt: Entsprechende Impulse werden über die Schreib-Auswahlleitung 29 und die Adreß-Schreibleitung 28 zugeführt, so daß der Schreibdecodierer 27 die nach der Speicherzelle 21 führende Wort-Schreibleitung 31 auswählt. Die anderen Wort-Schreibleitungen 31a und 31b bleiben auf ihrer Ruhespannung. Der Lesedecodierer 30 wird nicht eingeschaltet, und alle Wort-Leseleitungen 33, 33a und 33b bleiben auf ihrer Ruhespannung. Da in diesem Fall die Information nicht aus einer anderen Speicherzelle übertragen wird, werden die Bit-Leseleitungen 39 und 40 nicht benutzt und die Steuerleitung 43 ist so vorgespannt und die Schalter 37 und 38 sind so eingestellt, daß die Datenbit-Eingangsleitungen 35 und 36 nunmehr eindeutig an den Basiselektroden der als Emitterfolger geschalteten Transistoren 62 und 61 angeschlossen sind. Die in die Speicherzelle 21 einzuspeichernde Information wird nun den Schreib-Eingangsleitungen 35 und 36 zugeführt und den Basiselektroden der Transistoren 61 und 62 zugeleitet. Soll der Betriebszustand der Speicherzelle 21 von einer 1 auf eine 0 geändert werden, dann muß der Transistor 51 entsperrt und der Transistor 50 gesperrt werden. Dies wird dadurch erreicht, daß über die Datenbit-Eingangsleitung 35 ein positiver und über die Datenbit-Eingangsleitung 36 ein negativer Impuls zugeführt wird. Dies hat zur Folge, daß der als Emitterfolger geschaltete Transistor 62 leitend und der als Emitterfolger geschaltete Transistor 61 gesperrt wird. Wenn der Transistor 62 leitet, dann steigt das Potential auf der Bit-Schreibleitung 68 auf +V an, so daß an der Basiselektrode des Schreibtransistors 57 das Potential so weit ansteigt, daß der Schreibtransistor 57 leitend wird. Ist dies der Fall, dann geht das Potential des Knotenpunktes 53 und der Basiselektrode des Transistors 50 auf das Potential der Wort-Schreibleitung 31, wodurch Transistor 50 gesperrt wird. Wegen der Kreuzkopplung der beiden Transistoren steigt das Potential am Knotenpunkt 52 an, so daß der Transistor 51 leitend wird. Wie der Transistor 51 einschaltet, bleibt das Potential am Knotenpunkt 53 niedrig und der Transistor 50 bleibt gesperrt. Der Zustand der Speicherzelle 21 ist nunmehr von einer 1 auf eine 0 umgeschaltet.

Es sei darauf hingewiesen, daß die als Emitterfolger geschalteten Transistoren 61 und 62 dann weggelassen werden können, wenn die Schaltung so aufgebaut wird, daß ausreichende Signalpotentiale auf den Bit-Schreibleitungen 67 und 68 selbst dann erzielt werden können, wenn die Schreibtransistoren 56 und 57 in die Sättigung gehen.

Die vorliegende Erfindung hat eine Reihe von Vorteilen, nämlich sie läßt sich sehr schnell lesen und sehr schnell einschreiben. Da im übrigen die Lastwiderstände 54, 55 und 60 alle integrierte Widerstände, sogenannte Pinch-Widerstände sind, läßt sich die gesamte Schaltung als integrierte Schaltung aufbauen, so daß nur eine sehr geringe Leistung erforderlich ist. Außerdem läßt sich die Schaltung als integrierte Schaltung mit außerordentlich hoher Schaltungsdichte aufbauen.

## Patentansprüche

1. Speicheranordnung zum gleichzeitigen Lesen und Schreiben mit zeilen- und spaltenweise angeordneten, aus einem Paar kreuzgekoppelten Transistoren (50, 51) bestehenden Speicherzellen und einem Paar Schreibtransistoren (56, 57), mit einem Lesedecodierer (30) und einem Schreibdecodierer (27) die voneinander unabhängig mit den Speicherzellen verbunden sind, wobei die Speicherzellen (21, 24; 22, 25; 23, 26) jeder Zeile (10 bis 12) an einer der Wortschreibleitungen (31) des Schreibcodierers (27) und an einer der Wortleseleitungen (33) des Lesedecodierers (30) angekoppelt sind und die Speicherzellen jeder Spalte (13, 14) zwischen einem Paar von Bit-Leseleitungen (39, 40) und einem Paar von Bit-Schreibleitungen (67, 68) eingeschaltet sind, wobei zwei Bezugsknotenpunkte (52, 53) einer jeden Speicherzelle an die beiden dazugehörigen Bitleseleitungen (39, 40) ankoppelbar sind und die beiden Schreibtransistoren (56, 57) jeder Speicherzelle von dem zugeordneten Paar von Bitschreibleitungen (67, 68) und den zugeordneten Wortschreibleitungen (31) angesteuert werden und ausgangsseitig auf die Bezugsknotenpunkte (52, 53) wirken und wobei ferner simultan in Speicherzellen derselben Spalte ausgelesen und eingeschrieben werden kann, dadurch gekennzeichnet, daß eine Rückkopplungsschaltung für jede Spalte vorgesehen ist, die jeweils mit dem Paar von Bit-Leseleitungen (39, 40) dieser Spalte über ein Paar von Rückkopplungsleitungen (42, 41) verbunden ist und zwei Umschalter (37, 38) aufweist, die wahlweise ein Paar von Datenbiteingangsleitungen (35, 36) oder das Paar von Rückkopplungsleitungen (42, 41) an das Paar von Bit-Schreibleitungen (67, 68) anschalten.

2. Anordnung nach Anspruch 1, dadurch gekennzeichnet, daß jede Rückkopplungsschleife einen als Emitterfolger geschalteten Transistor (62, 61) enthält, dessen Basiselektrode an einer der Bitleseleitungen (39, 40) angekoppelt ist und dessen Emitterelektrode an der entsprechenden Bit-Schreibleitung (67, 68) angeschlossen ist.

3. Anordnung nach Anspruch 1 und 2, dadurch gekennzeichnet, daß jeder Umschalter (37, 38) aus einem Paar UND-Gliedern besteht, die ausgangsseitig in einer ODER-Verknüpfung zusammengeschaltet sind.

## Claims

1. Memory array for simultaneously reading and writing, comprising memory cells arranged in rows and columns and sonsisting of a pair of cross-coupled transistors (50, 51), and a pair of writing transistors (56, 57) with a read decoder (30) and a write decoder (27) which are connected to the memory cells independently of each other, the memory cells (21, 24; 22, 25; 23, 26) of each row (10 to 12) being coupled to one of the word write lines (31) of the write decoder (27), and to one of the word read lines (33) of the read decoder (30), and the memory cells of each column (13, 14) being inserted between a pair of bit read lines (39, 40) and a pair of bit write lines (67, 68), two reference nodes (52, 53) of each memory cell being such that they can be coupled to the two associated bit read lines (39, 40), and the two write transistors (56, 57) of each memory cell being addressed by the associated pair of bit write lines (67, 68) and the associated word write lines (31), and acting on the reference node (52, 53) on the output side, whereby simultaneous reading and writing can be carried out in memory cells of the same column, characterized in that a feedback circuit is provided for each column which is respectively connected to a pair of bit read lines (39, 40) of this column via pair of feedback lines (42, 41), and which comprises two switches (37, 38) selectively connecting a pair of data bit input lines (35, 36), or the pair of feedback lines (42, 41) to the pair of bit read lines (67, 68).

2. Arrangement as claimed in claim 1, characterized in that each feedback loop includes an emitter follower transistor (62, 61) having its base electrode connected to one of the bit read lines (39, 40), and having its emitter electrode connected to the corresponding bit write line (67, 68).

3. Arrangement as claimed in any one of claims 1 and 2, characterized in that each switch (37, 38) consists of a pair of AND circuits connected as an OR circuit at their output side.

## Revendications

1. Dispositif de mémorisation pour la lecture et l'écriture simultanée formé de cellules de mémoire constituées d'une paire de transistors (50, 51) couplés en croix et disposées en lignes et en colonnes et d'une paire de transistors d'écriture (56, 57), un d'décodeur de lecture (30) et d'un décodeur d'écriture (27) qui sont reliés, indépendamment l'un de l'autre, aux cellules de mémoire dans lequel dispositif de mémorisation, les cellules de mémoire (21, 24; 22, 25; 23, 26) de chaque ligne (10 à 12) sont couplées à l'une des lignes d'écriture de mots (31) du décodeur d'écriture (27) et à l'une des lignes de lecture de mots (33) du décodeur de lecture (30), les cellules de mémoire de chaque colonne (13, 14) sont intercalées entre une paire de lignes de lecture de bits (39, 40) et une paire de lignes d'écriture de bits (67, 68), dans lequel deux points de jonction (52, 53) de chaque cellule de mémoire peuvent être couplés aux deux lignes de lecture de bits (39, 40) associés, les deux transistors d'écriture (56, 57) de chaque cellule de mémoire étant attaqués par la paire de lignes d'écriture de bits (67, 68) associée et par les lignes d'écriture de mots (31) associées et agissant, du côté sortie, sur les points de jonction (52, 53), le dispositif de mémorisation étant tel qu'il est possible, en plus, de lire et d'écrire simultanément dans des cellules de mémoire de la même colonne, ce dispositif est caractérisé par le fait que, pour chaque colonne, est prévu un circuit de réaction qui est respectivement relié, par l'intermédiaire d'une paire de lignes de réaction (42, 41), à la paire de lignes de lecture de bits (39, 40) de cette colonne et qui présente deux inverseurs (37, 38) qui relient, au choix, une paire de lignes d'entrée de bits de connées (35, 36) ou la paire de lignes de réaction (42, 41) à la paire de lignes d'écriture de bits (67, 68).

2. Dispositif selon la revendication 1, caractérisé par le fait que chaque boucle de réaction contient un transistor (62, 61) monté en émetteur suiveur dont l'électrode de base est couplée à l'une des lignes de lecture de bits (39, 40) et dont l'électrode d'émetteur est reliée à la ligne d'écriture de bits (67, 68).

3. Dispositif selon l'une quelconque des revendications 1 et 2, caractérisé par le fait que chaque inverseur (37, 38) est composé d'une paire d'opérateurs ET qui sont interconnectés, du côté sortie, en une disjonction OU.

FIG. 1

FIG. 2